# EUROPEAN PATENT APPLICATION

(11) **EP 4 718 571 A1**
(43) Date of publication of application: **01.04.2026**
(21) Application number: 25188007.6
(22) Date of filing: 08.07.2025
(51) Int. Cl.: H01M 10/42, B29C 45/00, H01M 50/227, H01M 50/242, H01M 50/244, H01M 50/271, H01M 50/278, H01M 50/284, H05K 1/18

(54) **METHOD OF MANUFACTURING POWER SOURCE UNIT**

(30) Priority: 27.09.2024 US 202418899052
(71) Applicant: Treon Oy, 33720 Tampere (FI)
(72) Inventor: Kakkonen, Lari, 33720 Tampere (FI); Vesa, Mikko, 33720 Tampere (FI); Ylä-Outinen, Topi, 33720 Tampere (FI)
(74) Representative: Moosedog Oy

(57) **Abstract**

Disclosed is method for manufacturing power source unit (200, 300) comprising: assembling battery unit (302) by: arranging first terminal (FT) (210A, 304A) and second terminal (ST) (210B, 304B) on printed circuit board (PCB) (202, 306) on opposite edges of PCB; applying first adhesive (FA) (212, 308) on PCB between FT and ST; attaching battery (204, 310) with FA to PCB; attaching first electrode (214A, 312A) of battery to FT and second electrode (214B, 312B) to ST; and attaching cap (206, 314) over portion of battery; inserting battery unit in first mould half (FMH) (322A); removably attaching second mould half (SMH) (322B) and FMH to form a manufacturing mould (324); clamping protrusion between FMH and SMH; filling volume (328) between battery unit and walls of manufacturing mould to form damping element (208, 330); curing one moulding material; and separating FMH and SMH to obtain manufactured power source unit.

## Description

### TECHNICAL FIELD

The present disclosure relates to methods for manufacturing a power source unit.

### BACKGROUND

Vibration measurement is essential for monitoring performance of various mechanical devices such as motors, pumps, fans, and similar. The existing vibration measurement devices often face challenges related to an impact of a mass of a battery on accuracy of measurement data collected using the existing vibration measurement devices. The mass of the battery leads to vibration resonance within the vibration measurement device, which may lead to distorted measurement results and reduced performance. Moreover, the use of the battery that has more capacity and is comparatively larger in size than traditional batteries is also impossible to operate within the vibration measurement device, because when the mass of the battery increases the vibration resonance also increases. Additionally, the batteries have different internal structures which may further exacerbate the vibration resonance.

Existing techniques often involve the use of batteries that have low capacity, which reduces the size of the battery, but helps in reduction of the vibration resonance. Moreover, the battery and an internal structure of the battery are manufactured by reducing allowable deviation in the dimensions of the battery and the internal structure. Such reduction in allowable deviation results in reducing the vibration resonance issue. However, this increases the implementation cost and will not help with the battery's internal structure. Additionally, the use of batteries having low-capacity limits usage of the battery and thus reduces an overall performance of the vibration measurement device. The existing technique also allows attaching the battery with the internal structure using a mechanical locking feature to reduce the mass and to minimize the vibration resonance issue. However, attaching the battery with the mechanical locking feature can be effective for holding the battery in place but it may not eliminate tolerances or the vibrational resonances of the internal structure.

Therefore, in light of the foregoing discussion, there exists a need to overcome the aforementioned drawbacks.

### SUMMARY

The aim of the present disclosure is to provide a method for manufacturing a power source unit to create a robust power source unit which helps absorb resonances and eliminates tolerance gaps within the power source unit. The aim of the present disclosure is achieved by a method for manufacturing power source units as defined in the appended independent claims to which reference is made to.

The embodiments of the present disclosure substantially enable to improve the reliability and performance of power source units by reducing vibrational impact and ensuring consistent assembly quality. Additional aspects, advantages, features, and objects of the present disclosure would be made apparent from the drawings and the detailed description of the illustrative embodiments constructed in conjunction with the appended claims that follow.

Throughout the description and claims of this specification, the words "*comprise*", "*include*", "*have*"*,* and "*contain*" and variations of these words, for example "*comprising*" and "*comprises*"*,* mean "*including but not limited to*", and do not exclude other components, items, integers or steps not explicitly disclosed also to be present. Moreover, the singular encompasses the plural unless the context otherwise requires. In particular, where the indefinite article is used, the specification is to be understood as contemplating plurality as well as singularity, unless the context requires otherwise.

### BRIEF DESCRIPTION OF THE DRAWINGS

FIG. 1 is an illustration of a flowchart depicting steps of a method for manufacturing a power source unit, in accordance with an embodiment of the present disclosure.
FIG. 2 is an illustration of an exploded perspective view of a power source unit, in accordance with an embodiment of the present disclosure;
FIG. 2A is an illustration of a shape of a given terminal (namely, a first terminal and/or a second terminal) of FIG. 2, and FIG. 2B is an illustration of an arrangement of the given terminal on a printed circuit board (PCB) of FIG. 2, in accordance with an embodiment of the present disclosure;
FIGs. 3A, 3B, 3C, 3D, 3E, 3F and 3G collectively, are illustrations of perspective views of an exemplary manufacturing process of a power source unit, and FIG. 3G is an illustration of a cross-section view of the power source unit, in accordance with an embodiment of the present disclosure; and
FIG. 4 is an illustration of a cross-section view of a device comprising a power source unit of FIG. 3F, in accordance with an embodiment of the present disclosure.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

In a first aspect, the present disclosure provides a method for manufacturing a power source unit according to claim 1, the method comprising:
assembling a battery unit by:
   arranging a first terminal and a second terminal on a printed circuit board (PCB) on opposite edges of the PCB;
   applying a first adhesive on an area on the PCB between the first terminal and the second terminal;
   attaching a battery with the first adhesive to the PCB;
   attaching a first electrode of the battery to the first terminal and a second electrode of the battery to the second terminal; and
   attaching a cap, comprising a protrusion, at least partly over a portion of the battery;
inserting the battery unit in a first mould half ;
removably attaching a second mould half to the first mould half to form a manufacturing mould;
clamping the protrusion between the first mould half and the second mould half to keep the battery unit stationary and at least partly apart from walls of the manufacturing mould;
filling volume between the battery unit and the walls of the manufacturing mould with at least one moulding material to form the damping element;
curing the at least one moulding material; and
separating the first mould half and the second mould half from each other to obtain the manufactured power source unit.

The present disclosure provides the aforementioned method for manufacturing the power source unit which facilitates a strong, integrated structure, of the power source unit. The method simplifies the manufacturing of the power source unit by assembling a battery unit, wherein the PCB is arranged along a longitudinal dimension of the battery and is attached to each other to establish electrical connections. The electrical connections reduce a number of steps and ensures an efficient production process. By positioning the power source and the cap within the manufacturing mould and filling the at least one moulding material in the volume a strong, integrated structure is created. This makes the power source unit resistant to mechanical stresses and/or vibration resonance. Moreover, the method is cost-effective due to streamlined assembly process and an ability to produce durable, high-quality power source units. Furthermore, the use of the manufacturing mould ensures that each power source unit is produced to the same specifications, resulting in consistent quality and performance. The battery in the battery unit is placed accurately on the PCB using the first adhesive. The battery unit is placed along the centre line of the manufacturing mould, thereby preventing any misalignment during manufacturing the power source unit. The aforementioned method is simple and can be implemented with an ease.

Throughout the present disclosure, the term "*power source unit*" refers to a component that provides electrical power to a device. The power source unit keeps the battery tightened within the device. Optionally, the power source unit is designed to be received in a device, when is use. In an instance, the power source unit is connectable into a body of the device. In such an instance, the device has a rigid internal structure. In another instance, the power source unit is connectable outside of a body of the device. In both the instances, an electrical pathway is established between the power source unit and the device, wherein the electrical pathway is established by utilising at least one of: a physical wire, an electrical contact, a connector. Moreover, the device receives the electrical power from the power source unit, thus enabling the device to perform required functions. Examples of the device may include, but are not limited to, a pump, a motor, a compressor. A technical effect is that the ease of replacing the power source unit without dismounting the device ensures that the device can remain operational with minimal downtime

Optionally, the device is implemented as a vibration measurement device. In this regard, the term "*vibration measurement device*" refers to an instrument designed to detect, measure and analyse vibrations in various mechanical systems such as motors, pumps, fans and the like. Moreover, the vibration measurement device can be an acceleration transducer, wherein the acceleration transducer is used to measure an acceleration data of the device. Furthermore, the acceleration transducer is implemented as any one of: an accelerometer sensor, a magnetometer. Herein, the acceleration data comprises at least one of: a vibration data, a rotational speed, of the device. When the acceleration transducer is implemented as the accelerometer sensor, the accelerometer sensor could be based on microelectromechanical systems (MEMS) technology accelerometer. Moreover, an orientation mechanism of the accelerometer sensor is to align an accelerometer axis with the device to maximise a measurement performance of the accelerometer sensor. A technical effect is that the device implemented as the vibration measurement device could be used for monitoring vibrations of the device in order to plan and execute maintenance or to predict maintenance actions.

Throughout the present disclosure, the term "*battery unit*" refers to a complete assembly comprising the battery, the first electrode and the second electrode of the battery, the PCB, the first terminal and the second terminal of the PCB, and the first adhesive. Typically, the battery unit is essential for powering the device. Advantageously, the battery unit ensures that the device has a stable and reliable power source, critical for the operation of the device.

Throughout the present disclosure, the term "*printed circuit board*" refers to a platform that is provided for arrangement and interconnection of electronic components. Herein, the electronic components are Surface Mount Device (SMD) components, wherein such electronic components are mounted directly on a surface of the PCB instead of being inserted through holes. Throughout the present disclosure, the term "*terminal*" refers to an electrical connection point that attached to the PCB to transfer electrical power to the PCB. In this regard, the electronic components are designed with any one of contacts that are small and/or flat, lead wires, that are soldered directly on the base of the PCB. The electronic components are arranged on the base of the PCB on that side where the first terminal and the second terminal are arranged. Moreover, the electronic components are arranged along those edges of the PCB that are different from the opposite edges where the first terminal and the second terminal are arranged. Additionally, the electronic components are installed on at least one of: a top side, a bottom side, of the base of the PCB. It will be appreciated that the electronic components are not connected to the battery of the power source unit. Examples of such electronic components may include, but are not limited to, resistors, capacitors, diodes, and integrated circuits.

The first terminal and the second terminal of the PCB facilitate electrical connections with components that are external to the power source unit, thereby enhancing a versatility of the power source unit. A material used for manufacturing the first terminal and the second terminal is a conductive material, which facilitates conduction of electricity. Examples of the conductive material may include, but are not limited to, copper, phosphor bronze, and nickel. Moreover, the first terminal is placed on one edge of the PCB, while the second terminal is placed on the opposite edge. The terminals serve as connection points for the battery, facilitating the flow of electrical current to and from the PCB. Advantageously, by placing the first terminal and the second terminal at opposite ends of the PCB, the electrical path across the PCB is maximized, reducing potential interference and noise in the circuit.

Throughout the present disclosure, the term "*adhesive*" refers to a bonding agent that is used to secure components in place. In this regard, the first adhesive is applied on the base of the PCB on that side where the first terminal and the second terminal are arranged. The first adhesive is applied away from the edges of the PCB, such that dimensions of the first adhesive is less than dimensions of the PCB. When the battery is to be arranged on the PCB, the first adhesive is applied in such a manner such that at least one of: the battery is placed in a predetermined location (for example, such as a middle) on the PCB, the battery is maintained on an axis passing centrally through a longitudinal dimension of the PCB.

Optionally, the first adhesive is a heat-curable adhesive, a double-sided adhesive, a liquid glue or a combination of the aforementioned. In this regard, the term "*heat-curable adhesive*" refers to an adhesive material that transforms from a liquid or malleable state to a solid, durable bond when exposed to a specific temperature. Typically, the heat-curable adhesives create stronger bonds compared to adhesives that cure at room temperature. Moreover, the heat-curable adhesive is applied to the surfaces that need to be bonded, such as the base of the PCB and the battery. After application, heat is applied to the adhesive, either through a heating element, oven, or other heat sources. The heat triggers a chemical reaction in the adhesive, leading to a solidification process that bonds the components together. The term "*double-sided adhesive*" refers to an adhesive material that provides adhesive on both its upper and lower surfaces. Typically, the double-sided adhesive is in the form of a tape or thin film that can be applied between two components, such as the battery and the PCB, to bond them together securely. The term "*liquid glue*" refers to an adhesive substance that is initially in a fluid or semi-fluid state, allowing it to be easily spread on the base of the PCB. Notably, the liquid glue attached to the surface of the battery and the base of the PCB and facilitates bonding therebetween. It will be appreciated that the first adhesive can also be a combination of the aforementioned adhesives. Moreover, by specifying multiple adhesive options for the first adhesive, the method allows for adaptability in the manufacturing process. Different adhesives can be chosen based on the specific materials, environmental conditions, and performance requirements. A technical effect is that the option to combine different adhesives allows for optimized bonding characteristics, such as combining the strength of a heat-curable adhesive with the gap-filling properties of a liquid glue, resulting in a more robust and reliable attachment. Additionally, different options for the first adhesive provides stability, durability and reliability to the device.

The battery is attached on the base of the PCB by adhesion using the first adhesive. The term "*battery*" refers to an electrochemical device that stores and supplies electrical energy to the PCB and other components in the device. Notably, the battery is the primary source of power for the device, enabling it to operate by providing the necessary voltage and current. Herein, the battery is any one of: a rechargeable battery, a non-rechargeable battery. Examples of the battery may include, but are not limited to, a Lithium-ion battery, a Lithium polymer battery, an alkaline battery, and a Nickel Metal Hydride battery. For example, the battery may be an AA Lithium Thionyl chloride (Li-SOCl2) battery.

Optionally, the method further comprises curing the first adhesive applied on the area on the PCB for attaching the battery thereto, prior to attaching the first electrode of the battery to the first terminal and the second electrode of the battery to the second terminal. In this regard, the term "*curing*" refers to a process of hardening or setting the first adhesive after attaching the battery with the first adhesive to the PCB. Typically, during the curing process, the first adhesive transitions from a liquid or semi-liquid state to a solid state, forming a strong and durable bond. Notably, the curing ensures that the first adhesive reaches its optimal bonding strength and durability. Moreover, the curing of the first adhesive allows to maintain the alignment and connection of the components during the operational working of the device. Furthermore, the curing is achieved by applying heat, which triggers a chemical reaction in the adhesive to harden it. A technical effect is that by curing the first adhesive before attaching the battery electrodes to the terminals, the first adhesive provides a stable base that prevents movement or misalignment during the attaching process, ensuring accurate electrical connections.

Notably, the PCB is assembled in a longitudinal dimension with the battery. The battery is attached on that side where the given terminal is arranged on the PCB. A first electrode of the battery is any one of an anode or a cathode, and A second electrode of the battery is another one of the cathode or the anode. In one embodiment, the first electrode and the second electrode are on opposite ends of the battery. In another embodiment, the first electrode and the second electrode are on a same end of the battery. Optionally, the first electrode and the second electrode of the battery is extended to a side of the battery to reduce an effect of external vibration and thus enables accurate measurement of the acceleration data. In this regard, when the battery is arranged on the base of the PCB, the first electrode of the battery is attached to the first terminal. Similarly, the second electrode of the battery is attached to the second terminal arranged on the PCB. Moreover, attaching the first electrode with the first terminal of the PCB establishes an electrical connection between the first electrode and the first terminal, and attaching the second electrode with the second terminal of the PCB establishes an electrical connection between the second electrode and the second terminal. Additionally, such attaching tightens the battery within the power source unit. Herein, the attaching is performed using a attaching process, for example, such as, welding, soldering, adhesive or mechanical fixation, thermal bonding and the like. Such attaching processes are well-known in the art.

Optionally, the method further comprises applying a protective coating over the attached first electrode and the attached second electrode. In this regard, the term "*protective coating*" refers to a layer of protective material that is applied over the attached first electrode and the attached second electrode. Notably, the protective coating protects the attached first and the second electrode from external factors such as moisture, corrosion, mechanical damage, and environmental degradation. Moreover, the protective coating ensures the longevity and reliability of the electrical connections by creating a barrier that prevents exposure to elements that could compromise the integrity of the welds. Furthermore, the protective coating can be applied using various techniques (such as, spraying, dipping, or brushing the coating material over the attached areas) depending on the material used for the attaching. Furthermore, the material used for the protective coating may include, but are not limited to, silicone, epoxy, and the like insulating compounds. A technical effect is applying the protective coating is to enhance the lifespan of the attached portion of the first and the second electrode and thus to ensure that the electrical performance of the device remains stable over its intended lifespan.

Throughout the present disclosure, the term "*cap*" refers to a component that is designed to cover or enclose a part of the battery. Notably, the cap provides coverage and protection to the battery. Moreover, the cap is used to encase in the first internal hollow space, that portion of the battery wherein any one of: the first electrode, the second electrode, is an anode, such that either the first electrode and/or the second electrode is covered by the second end of the cap. The cap supports the battery in place when moulding the damping element (as will be described later). Additionally, the cap is used as an interface to tighten the battery in the power source unit, when the power source unit is fully manufactured. In this regard, a vertical tightening force is transformed into a horizontal tightening force, thus removing any gap between the cap and the battery. The term "*protrusion*" refers to a raises part of the cap that interacts with the battery and other components of the power source unit, when the power source unit is fully manufactured. Notably, the protrusion is an extended part of the cap that may stick out from the cap's surface. Moreover, the protrusion can vary in shape (such as cylindrical, rectangular and the like).

Optionally, the first end of the cap is open, and the second end of the cap is closed, wherein the first end and the second end are two extremities of the cap. The first receiving portion of the cap is an elongated portion that extends from the second end to the first end. Herein, the first internal hollow space receives any one of: the first electrode that is attached to the first terminal of the PCB, the second electrode that is attached to the second terminal of the PCB. Optionally, the first internal hollow space receives a portion of the PCB also that comprises the given terminal. In other words, when the first internal hollow space receives the portion of the battery that has the first electrode, said first internal hollow space also receives the first terminal to which the first electrode is attached. Alternatively, when the first internal hollow space receives the portion of the battery that has the second electrode, said first internal hollow space also receives the second terminal to which the second electrode is attached. The cap is attached in such a manner so that the cap remains in position over a designated area of the battery. It will be appreciated that the cap is glued to the battery and/or on the PCB so that the battery is stable inside the cap during the moulding process (as will be discussed later). Optionally, the protrusion of the cap lies along a largest diameter of the centre of the second end.

Optionally, the method further comprises manufacturing the cap of the power source unit using a non-conductive material. In this regard, the term "*non-conductive material*" refers to a material that does not allow the flow of electrical current through itself. Notably, the cap does not conduct electricity, hence the cap does not interfere with the electrical connections that are established between the battery and the PCB. Such non-conductive material could be a plastic material, for example, such as polyamide, polyethylene, polypropylene, and polyethylene terephthalate. A technical effect is that the cap does not inadvertently create electrical pathways that could lead to short circuits or other electrical failures in the power source unit.

Optionally, the non-conductive material of the cap of the power source unit is one of the following materials: plastic, polyamide, fiberglass, polycarbonate. In this regard, the term "*plastic*" refers to a synthetic material made from a wide range of organic polymers, such as polyethylene, PVC, nylon, polypropylene, polyethylene terephthalate, acrylics, polyester and the like. Notably, the plastic is inherently poor conductors of electricity, making it suitable for making the cap. Moreover, the plastic can be easily shaped to make different shapes of the cap when heated, then cooled to maintain a desired shape. The term "*polyamide*" refers to a synthetic polymer that is used to make the cap of the power source unit. Typically, the polyamide is an electrical insulator that makes it suitable for applications requiring non-conductive materials. Notably, use of the polyamide is able to provide the cap with excellent mechanical strength and durability, ensuring that the cap can protect the internal components of the power source unit effectively. The term "*fiberglass*" refers to a composite material made from fine fibers of glass woven together and embedded in a resin matrix. Notably, the fiberglass is used to make the cap of the power source unit. Furthermore, use of the fiberglass is able to provide the cap with a combination of strength and lightweight properties, enhancing the structural integrity of the power source unit while maintaining its ease of handling. The resistance of fiberglass to environmental factors like corrosion and heat would further contribute to the reliability and longevity of the power source unit. The polycarbonate refers to a type of thermoplastic polymer that is used to make the cap of the power source unit. Notably, the polycarbonate material is used as one of the materials for the cap to ensure that the power source unit is protected against physical impacts, heat, and electrical conduction. A technical effect of the choice of non-conductive material of the cap of the power source unit is one of the following materials: plastic, polyamide, fiberglass, polycarbonate is that the non-conductive material prevents unintended electrical conduction and enhance safety of the power source unit.

Throughout the present disclosure, the term "*mould*" refers to a designed frame or hollow form that is used to shape or encase the battery unit. The mould is a two-part mould having first mould half and a second mould half. In this regard, the term "*first mould half*" refers to one part of a two-part mould that is used in moulding process of manufacturing the power source unit. Notably, the first mould half comprise a cavity to partly encapsulate the battery unit within the first mould half. Moreover, the battery unit is carefully placed into the first mould half, ensuring it fits precisely within the mould cavity.

Throughout the present disclosure, the term "*second mould half*" refers to a second part of the two-part mould that is used in the moulding process of manufacturing the power source unit. Notably, the first mould half and the second mould half comprise respective cavities, wherein when the battery unit is enclosed within the first mould half and the second mould half, there is space for a damping element to be moulded around the battery unit. The removable attachment of the second mould half and the first mould half allows for ease of removal, later during the manufacturing of the power source unit (namely, manufactured power source unit). Herein, the first mould half and the second mould half are same as or different from each other. Moreover, the support is provided at the contact area and at opposite of the contact area of the battery unit with the first mould half and the second mould half, respectively. The term "*manufacturing mould*" refers to a combined assembly of the first mould half and the second mould half, which is used to fabricate the damping element.

Optionally, the first mould half and the second mould half are made of a fabrication material that is resistant to a curing temperature of the at least one moulding material, wherein the fabrication material is selected from at least one of: stainless steel, aluminium alloy, silicon rubber, polymer. In this regard, the term "*fabrication material*" refers to a material that is used to fabricate the first mould half and the second mould half. Notably, the fabrication material is chosen for its ability to withstand the curing temperatures of the at least one moulding material (as will be discussed later) involved in the moulding process without degrading, deforming, or losing its structural integrity. The term "*stainless steel*" refers to a steel alloy that is used as the fabrication material for making the first mould half and the second mould half. Notably, the stainless steel is used to make the fabrication material for its corrosion resistance quality, strength, and ability to withstand high temperatures. Herein, the term "*aluminium alloy*" refers to an alloy that is used as the fabrication material for making the first mould half and the second mould half. Typically, the aluminium alloy composed of primarily aluminium with other elements such as copper, magnesium, silicon, zinc or manganese to enhance the properties of aluminium. Notably, the aluminium alloy is lightweight that makes it easier to handle and to make a suitable material to make the first mould half and the second mould half. The term "*silicon rubber*" refers to a synthetic elastomer made from silicone that is used as the fabrication material for making the first mould half and the second mould half. Notably, the silicon rubber is highly flexible even at varying temperatures, making it ideal for making the moulds that require some degree of elasticity to release the device without damage. Moreover, the silicon rubber has excellent resistance to the curing temperature of the at least one moulding material. The term "*polymer*" refers to a synthetic or natural material composed of long, repeating chains of molecules that is used as the fabricating material to make the first mould half and the second mould half. Notably, the polymer can be tailored to have specific mechanical, thermal, and chemical properties to make the first mould half and the second mould half to resist the curing temperature of the at least one moulding material. Moreover, the polymer, as the fabrication material, may include polyethylene, polypropylene, thermosetting plastics (such as, epoxy, phenolic resins) and the like. A technical effect of using heat-resistant fabricating material is that first mould half and the second mould half will not deform, crack, or degrade under the high temperatures experienced during the curing process, that extends the mould's operational life and reduce the need for frequent replacements.

The first mould half and the second mould half are arranged in such a manner that the protrusion of the cap is clamped to align the battery unit within the manufacturing mould. Herein, the protrusion is clamped when the first mould half and the second mould half apply a pressure to hold said protrusion between the first mould half and the second mould half. The battery unit is positioned in such a way within the manufacturing mould that said battery unit is not in direct contact with the walls of the manufacturing mould and is at a particular distance away from the walls of the manufacturing mould. Such arrangement ensures that there is enough volume around the battery unit to form the damping element.

Optionally, the cap further comprising an extension, wherein at the step of clamping the protrusion between the first mould half and the second mould half, the extension keeps the battery unit stationary on a centre line of the manufacturing mould, wherein the centre line also passes centrally through the protrusion. In this regard, the term "*extension*" refers to a projection of the cap that extends outwards or beyond the main body of the cap. Notably, the extension is arranged in such a manner that when manufacturing the power source unit, the extension is arranged on a longitudinal dimension of the battery. The extension of the cap plays crucial role in maintaining the alignment of the battery unit along the manufacturing mould's centre line. Herein, the first mould half and the second mould half are removably attached at the centre line of the manufacturing mould. In this regard, the battery unit is securely positioned along the centre line of the manufacturing mould, thereby ensuring symmetrical placement of the battery unit along the centre line when clamping the protrusion. A technical effect of utilising the extension to keep the battery unit stationary on the centre line is that it ensures that the battery unit is positioned symmetrically for uniform fabrication of the damping element, thereby ensuring consistency and accuracy when manufacturing the power source unit.

Optionally, the method comprises using a gasket to keep the battery unit stationary on a centre line of the manufacturing mould. Herein, the term "*gasket*" refers to a flexible and compressible component designed to create a seal between the PCB and the battery. Typically, the gasket is made from materials that can be compressed, such as, rubber, silicone and the like elastomers. Notably, the gasket is used to fix the battery in the middle section of the PCB and subsequently, keeps the battery unit stationary on the centre line of the manufacturing mould. In this regard, the central line of the manufacturing mould is an imaginary line that runs through the central axis of the manufacturing mould. Moreover, when the mould halves are brought together, the gasket compresses, holding the battery unit in place along the centre line of the manufacturing mould. A technical effect of using the gasket is that the battery unit stationary and aligned on the centre line and ensures that the moulded parts fit together as intended, improving the overall quality and durability of the power source unit.

Optionally, the method further comprises applying a second adhesive on an inner side of the extension. Herein, the second adhesive is used to attach the cap to battery. It will be appreciated that the second adhesive can be similar or different form the first adhesive. Notably, the second adhesive is applied specifically to the inner side of the extension. Advantageously, the purpose of the second adhesive is to bond and secure the extension of the cap in place and/or to provide additional adhesion to battery unit when the first adhesive might not be sufficient. A technical effect of the second adhesive is to adhere the extension to the battery in such a way that the battery is aligned along the central line.

Optionally, a given adhesive is any one of: an adhesive glue, an adhesive tape. In this regard, the term "*given adhesive*" refers to the second adhesive that is applied on the area between the first terminal or the second terminal of the PCB and the inner side of the extension. When the second adhesive is the adhesive tape, such adhesive tape could be a double-sided tape, wherein a lower side of the double-sided tape adheres to the inner side of the extension and an upper side adheres to the longitudinal dimension of the battery. Alternatively, when the first adhesive is the adhesive glue, such adhesive glue applied on the inner side of the extension and on the longitudinal dimension of the battery that is placed inside the inner side of the extension of the cap covered with the adhesive glue. A technical effect is of using the given adhesive is any one of: an adhesive glue, an adhesive tape is to provide stronger or more durable bonds between the inner side of the extension and the battery unit, and provide more stability to the battery unit.

Optionally, the first mould half comprises a first support aligned with at least two contact pads of the PCB, and the second mould half comprises a second support opposite to the first support, wherein at the step of clamping the protrusion between the first mould half and the second mould half, the first support and the second support keeps the battery unit stationary on the centre line within the manufacturing mould. In this regard, the first support and the second support are features within the manufacturing mould to hold the battery unit securely at the particular distance away from the walls of the manufacturing mould. This particular distance may correspond to a thickness of the damping element that is to be moulded over the battery unit to manufacture the power source unit. Moreover, the first support provides the at least two contact pads of the PCB accessible, and the second support provides an opening for the extension of the cap. When the protrusion is clamped between the first mould half and the second mould half, it ensures that the battery unit remains fixed in place along the centre line within the manufacturing mould, to maintain consistency in the manufacturing process of the power source unit. A technical effect of providing the first support and the second support in such a manner is that it ensures consistency when manufacturing the power source units, resulting in uniformity when multiple such power source units are formed.

Throughout the present disclosure, the term "*moulding material*" refers to a material that is used in the moulding process to fill the space between walls of the manufacturing mould and a boundary of the battery unit. It will be appreciated that "*at least one moulding material*" refers to "*a single moulding material*" in some implementations, and "*a plurality of moulding materials*" in other implementations. Optionally, the at least one moulding material is a thermal insulating material adapted to protect the battery unit from external temperature variations. In this regard, the term "*thermal insulating material*" refers to an insulating material that is used in the moulding process to reduce or prevent the transfer of heat to the battery unit. Notably, the thermal insulating material form a barrier around the battery unit, helping to maintain a stable internal temperature by insulating the battery unit from external temperature changes. A technical effect of using the thermal insulating material for the at least one moulding material is to maintain a stable temperature that prevents fluctuations that could adversely affect the battery's operation and longevity.

Optionally, the at least one moulding material is at least one of: an elastic material, an elastomeric material, a non-homogenous material. Herein, the term "*elastic material*" refers to a type of material that is used as the at least one moulding material that can return to its original shape after being deformed. Typically, the elastic material may include, but are not limited to, rubber, latex and certain polymers. Notably, the elastic material is capable of undergoing deformation under stress and returning to their original shape when the stress is removed. The term "*elastomeric material*" refers to a material that exhibit properties that are similar to properties of the elastic material but exhibit rubber-like properties in terms of elasticity and/or flexibility. Typically, the elastomeric material may include natural rubber, silicone rubber, synthetic rubber (such as neoprene, Ethylene Propylene Diene Monomer) and the like. The term "*non-homogenous material*" refers to a material that has non-uniform composition throughout their structure, and often comprises multiple components within the non-homogenous material. Notably, the non-homogenous material may include composites (such as fiberglass, carbon fiber and the like), laminates and the like. A technical effect of having different moulding materials is that it enables customizing properties of the damping element as per requirement.

Throughout the present disclosure, the term "*volume*" refers to a space between the walls of the manufacturing mould and a boundary of the battery unit. The at least one moulding material is added in a manner that it fills the volume and conforms to a shape of the manufacturing mould. Herein, the at least one moulding material is in any one of: a liquid state, a semi-liquid state. Optionally, the second mould half further comprises a gate, wherein at the step of filling the volume between the battery unit and the walls of the manufacturing mould, the at least one moulding material is filled in the volume via the gate.

Optionally, the step of filling the volume with at least one moulding material employs an injection moulding process, a low pressure casting process, a hot melting process or a combination of the aforementioned. Herein, the term "*injection moulding process*" refers to a moulding process that is used to fill the volume between the battery unit and the walls of the manufacturing mould with at least one moulding material. Notably, in the injection moulding process, the at least one moulding material in pellet form is heated until it becomes molten. Subsequently, the molten material in injected under high pressure volume between the battery unit and the walls of the manufacturing mould. The at least one moulding material takes a shape of the volume. The at least one moulding material cools and solidified within the moulds to form its final shape. The term "*low pressure casting process*" refers to a casting process in which the at least one moulding material in molten state is filled in the volume between the battery unit and the walls of the manufacturing mould under low pressure. Notably, the low pressure casting process allows the at least one moulding material to fill the volume between the battery unit and the walls of the manufacturing mould slowly and evenly, reducing turbulence and minimizing the formation of defects such as air bubbles or voids in the said volume. Moreover, low pressure is applied on the surface of molten at least one moulding material to push the moulding material into the volume between the battery unit and the walls of the manufacturing mould. The at least one moulding material fills the volume slowly and steadily. The term "*hot melting process*" refers to a moulding process in which the at least one moulding material is heated and applied to fill the volume. Notably, in the hot melting process the at least one moulding material is melted and converted into a liquid form. Then the at least one moulding material in liquid form is filled in the volume between the battery unit and the walls of the manufacturing mould. Subsequently, the at least one moulding material is allowed to cool and solidify within the volume, forming the manufacturing mould. A technical effect of performing the filling of the volume with the aforementioned different processes is that the different moulding processes used with complementary properties of each process to make the manufacturing mould without defects and with enhanced durability.

Optionally, the at least one moulding material comprises a first moulding material and a second moulding material, wherein at the step of filling the volume between the battery unit and the walls of the manufacturing mould with the at least one moulding material, the first moulding material is filled in a portion within the volume, and the second moulding material is filled in a remaining portion within the volume. Herein, the first moulding material and the second moulding material are different from each other in terms of at least one of: a property, a composition, a characteristic. Moreover, the term "*first portion*" refers to a specific area within the volume that is around the boundary of the battery unit, and the term "*second portion*" is referred to remaining area within the volume that is around the walls of the manufacturing mould. When filling the at least one moulding material, the first moulding material is filled first in the first portion, and the second moulding material is filled second in the second portion. This creates the damping element which is a single structure with different moulding materials used. A technical effect of performing the step of filling the volume between the battery unit and the walls of the manufacturing mould in such a manner is that different moulding materials can be used with complementary properties, which can enhance a functionality of the damping element.

Throughout the present disclosure, the term "*damping element*" refers to a component that is designed to dampen vibrations and/or reduce disturbances within the power source unit, eliminate tolerance gap within an internal structure of the battery. Such vibrations and/or disturbances within the power source unit occur due to at least one of: resonance caused by a mass of the battery, resonance caused due to the internal structure of the battery. Moreover, the damping element is used for keeping the battery tightened and not add any additional vibrational error in the acceleration data.

Functionally, the damping element creates a firm attachment and eliminates the tolerance gap between the battery and a compartment within which the battery is arranged therein. Moreover, the damping element acts as a dampening feature between the battery and the compartment, which reduces an effective resonance of the mass of the battery. Hence, sensing abilities of the acceleration transducer becomes accurate, and a capacity of the battery increases when the damping element creates the firm attachment and acts as the damping feature. Additionally, the damping element provides a means for heat dissipation and provides protection to the power source unit from external shocks. Optionally, the damping element emulates as a temperature insulator.

The at least one moulding material which is filled in the volume between the battery unit and the walls of the manufacturing mould is cured. Herein, curing typically involves application of at least one of: heat, pressure, chemical agents, to transform the at least one moulding material from any one of: the liquid state, the semi-liquid state to the damping element having a solid state. In an implementation, the curing of the at least one moulding material is performed at ambient temperature. In another implementation, the curing of the at least one moulding material is performed at a high temperature that exceeds 200 degrees Celsius. When the at least one moulding material is cured at the high temperature, curing of the at least one moulding material takes less time than curing the at least one moulding material at the ambient temperature. In other words, curing the at least one moulding material can be accelerated upon application of heat.

Optionally, the cured damping element is adapted for providing mechanical shock absorption and vibration damping properties. Herein, the cured damping element has the ability to absorb and dissipate energy from mechanical shocks or vibrations. Moreover, the battery unit and other sensitive electronic components are prone to damage from mechanical shocks and vibrations, which can occur during handling, operation and the like. The cured damping element serves to protect these components by absorbing shocks and reducing the amplitude of vibrations. A technical effect of the cured damping element for providing mechanical shock absorption and vibration damping properties is that maintain the stability and performance of the battery unit and other components, preventing issues such as connection failures or premature wear and effectively dampen the vibrations within the power source unit.

Upon successful curing, the first mould half and the second mould half are separated to facilitate removal of the manufactured power source unit. Herein, the manufactured power source unit is moulded with the at least one moulding material and cured to form the damping element. Optionally, the manufactured power source unit can then be operatively connected to a device (as discussed earlier).

### DETAILED DESCRIPTION OF THE DRAWINGS

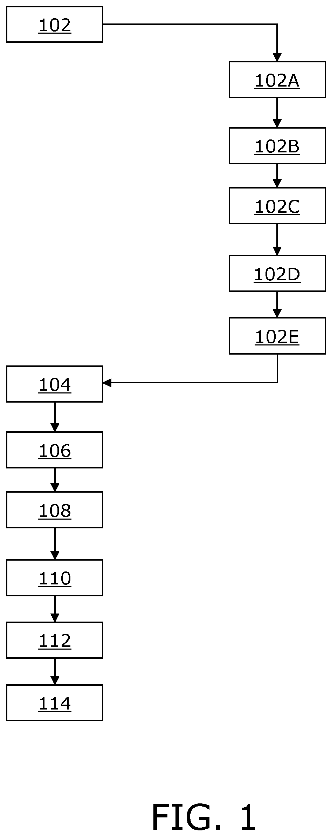

Referring to FIG. 1, illustrated is a flowchart depicting steps of a method for manufacturing a power source unit, in accordance with an embodiment of the present disclosure. At step **102,** a battery unit is assembled. Herein, steps **102A, 102B, 102C, 102D** and **102E** relates to the assembly of the battery unit. At step **102A,** a first terminal and a second terminal are arranged on a printed circuit board (PCB) on opposite edges of the PCB. At step **102B,** a first adhesive is applied on an area on the PCB between the first terminal and the second terminal. At step **102C,** a battery is attached with the first adhesive to the PCB. At step **102D,** a first electrode of the battery is attached to the first terminal and a second electrode of the battery is attached to the second terminal. At step **102E,** a cap is attached at least partly over a portion of the battery, wherein the cap comprises a protrusion. At step **104,** the battery unit is inserted in a first mould half. At step **106,** a second mould half and the first mould half are removably attached to form a manufacturing mould. At step **108,** the protrusion is clamped between the first mould half and the second mould half to keep the battery unit stationary and at least partly apart from walls of the manufacturing mould. At step **110,** a volume between the battery unit and the walls of the manufacturing mould is filled with at least one moulding material to form the damping element. At step **112,** the at least one moulding material is cured. At step **114,** the first mould half and the second mould half are separated from each other to obtain the manufactured power source unit.

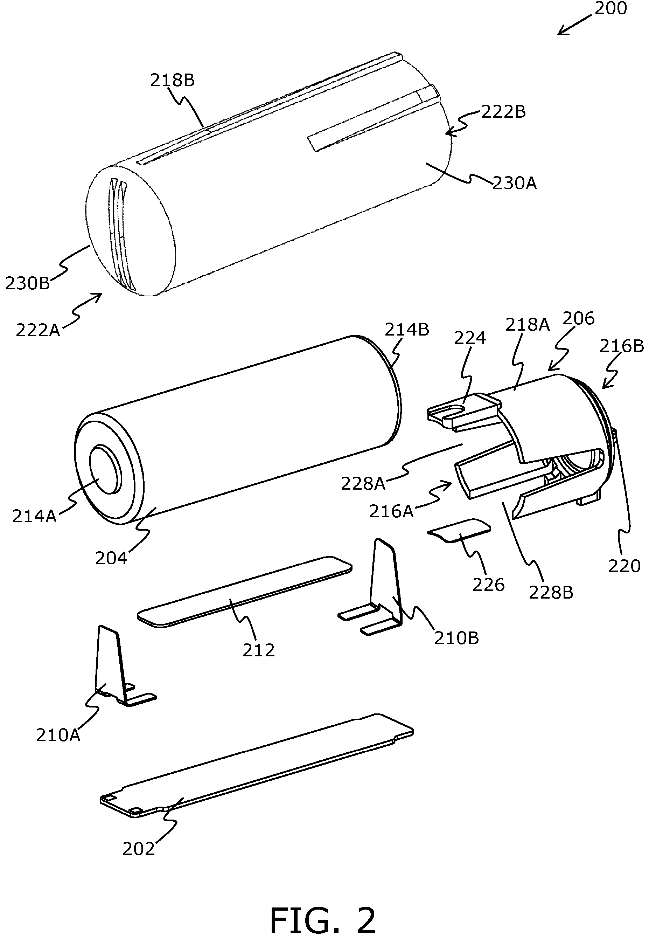

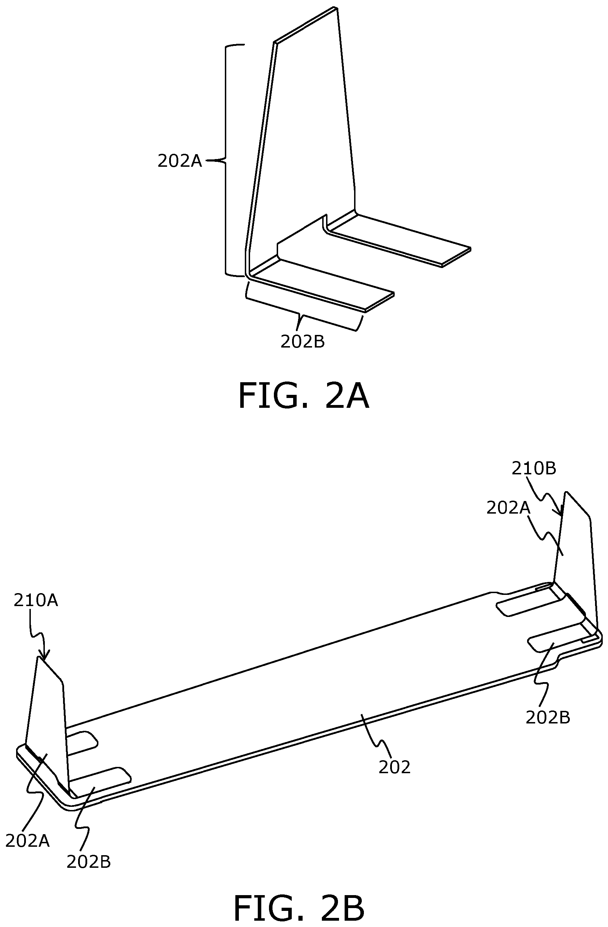

Referring to FIG. 2, illustrated is an exploded perspective view of a power source unit **200,** in accordance with an embodiment of the present disclosure. The power source unit **200** comprises a printed circuit board (PCB) **202,** a battery **204,** a cap **206,** and a damping element **208.** The PCB **202** comprises a first terminal **210A** and a second terminal **210B** arranged on opposite edges of the PCB **202,** and a first adhesive **212** on an area on the PCB **202** between the first terminal **210A** and the second terminal **210B.** The battery **204** comprises a first electrode **214A** and a second electrode **214B,** wherein the first electrode **214A** is attached to the first terminal **210A** and the second electrode **214B** is attached to the second terminal **210B.** The cap **206** comprises a first end **216A** and a second end **216B** that is opposite to the first end **216A,** a first receiving portion **218A** that extends from the second end **216B** to the first end **216A** to define a first internal hollow space that receives a portion of the battery **204,** and a protrusion **220** that extends outwards from a centre of the second end **216B.** Herein, the cap **206** is attached at least partly over the portion of the battery **204.** The damping element **208** comprises: a third end **222A** and a fourth end **222B** that is opposite to the third end **222A,** wherein the third end **222A** is closed, and the fourth end **222B** has a first opening through which the protrusion **220** extends outwards; and a second receiving portion **218B** that extends from the third end **222A** to the fourth end **222B** to define a second internal hollow space that accommodates at least partly the PCB **202,** the battery **204,** and the cap **206.**

Optionally, the power source unit **200** further comprises an extension **224** extending from the first receiving portion **218A.** Optionally, the extension **224** comprises a second adhesive **226** on an inner side of the extension **224.** Optionally, the first receiving portion **218A** of the cap **206** has at least two slots (depicted as two slots **228A** and **228B**).

It may be understood by a person skilled in the art that the FIG. 2 includes a simplified power source unit **200** for sake of clarity, which should not unduly limit the scope of the claims herein. The person skilled in the art will recognize many variations, alternatives, and modifications of embodiments of the present disclosure.

Referring to FIG. 2A, there is shown a shape of a given terminal (namely, a first terminal **210A** and/or a second terminal **210B**) of FIG. 2, and referring to FIG. 2B, there is shown an arrangement of the given terminal on a printed circuit board **202** of a power source unit **200** of FIG. 2, in accordance with an embodiment of the present disclosure. In FIG. 2A, the given terminal has a first portion **202A** and a second portion **202B** that extends from the first portion **202A** in a perpendicular manner. In FIG. 2B, the first portion **202A** is positioned vertically with respect to a base of the PCB **202,** and the second portion **202B** is positioned horizontally on the base of the PCB **202.**

FIGs. 2A-B are merely examples, which should not unduly limit the scope of the claims herein. A person skilled in the art will recognize many variations, alternatives, and modifications of embodiments of the present disclosure.

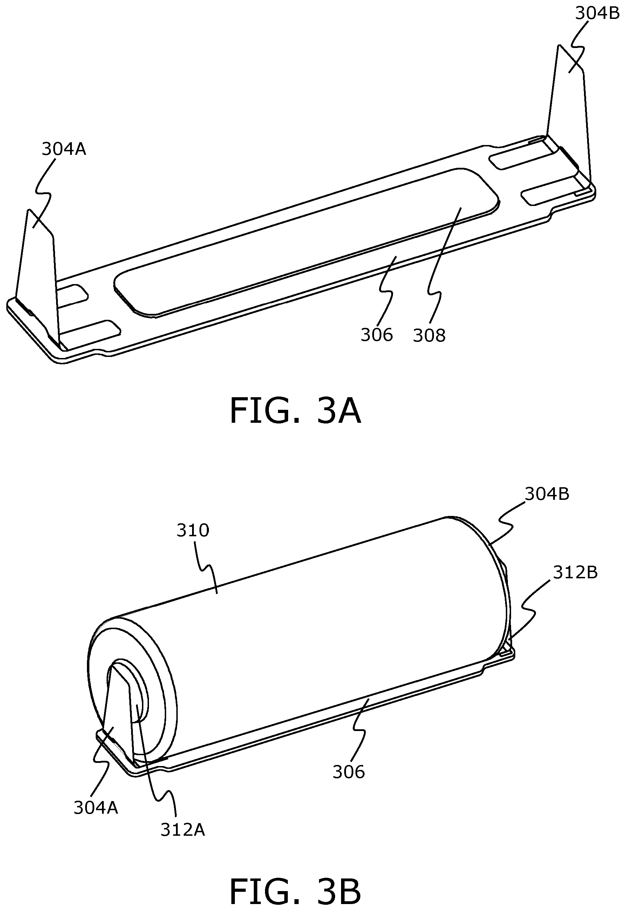

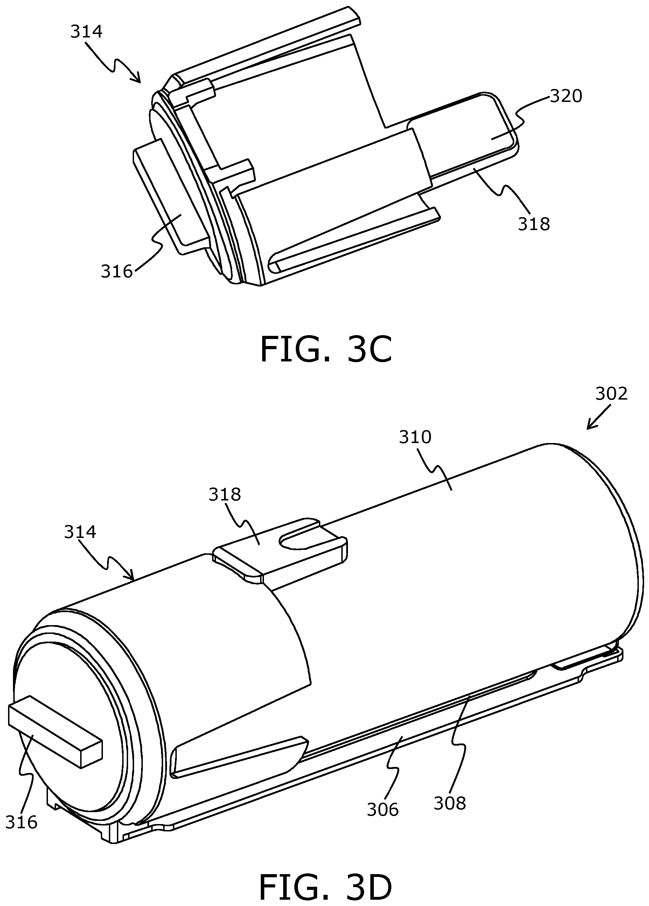

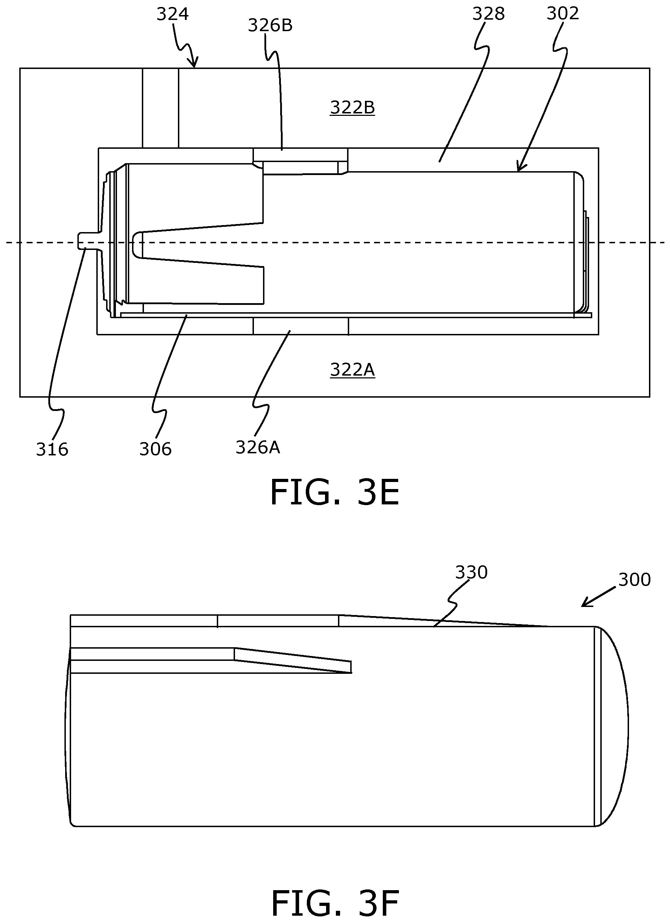

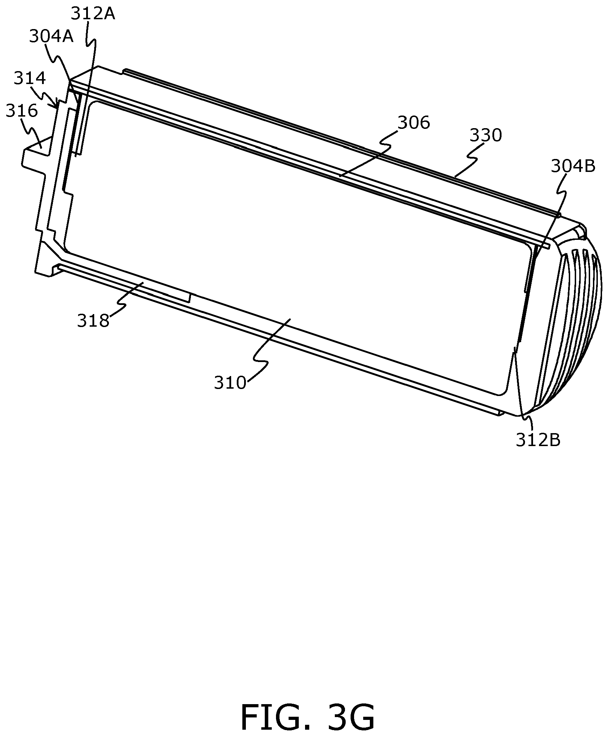

Referring to FIGs. 3A, 3B, 3C, 3D, 3E, 3F, and 3G collectively, there are shown perspective views of an exemplary manufacturing process of a power source unit **300,** and referring to FIG. 3H, there is shown a cross-section view of the power source unit **300,** in accordance with an embodiment of the present disclosure. Herein, the FIGs. 3A-C show assembly of a battery unit **302.**

In FIG. 3A, a first terminal **304A** and a second terminal **304B** are arranged on a printed circuit board (PCB) **306,** wherein the first terminal **304A** and a second terminal **304B** are arranged on opposite edges of the PCB **306.** A first adhesive **308** is applied on an area on the PCB **306** between the first terminal **304A** and a second terminal **304B.**

In FIG. 3B, a battery **310** is attached with the first adhesive **308** to the PCB **306.** A first electrode **312A** of the battery **310** is attached to the first terminal **304A** and a second electrode **312B** of the battery **310** is attached to the second terminal **304B.**

In FIG. 3C, illustrated is a cap **314** comprising a protrusion **316.** Optionally, the cap **314** comprises an extension **318.** Optionally, the extension **318** comprises a second adhesive **320** on an inner side of the extension **318.** In FIG. 3D, the cap **314** is attached at least partly over a portion of the battery **310** to form the battery unit **302.** In this regard, the extension **318** is arranged opposite to the PCB **306,** wherein the extension is adhered to the battery **310** using the second adhesive **320.**

In FIG. 3E, illustrated is a manufacturing of the power source unit **300.** In FIG. 3E, the battery unit **302** is inserted in a first mould half **322A.** A second mould half **322B** and the first mould half **322A** are removably attached to form a manufacturing mould **324.** The protrusion **316** is clamped between the first mould half **322A** and the second mould half **322B** to keep the battery unit **302** stationary and at least partly apart from walls of the manufacturing mould **324.** Optionally, the extension **318** keep the battery unit **302** stationary on a centre line (depicted as a dashed line) of the manufacturing mould **324,** wherein the centre line also passes centrally through the protrusion **316.** Optionally, the first mould half **322A** comprises a first support **326A,** and the second mould half **322A** comprises a second support **326B** opposite to the first support **326A.** A volume **328** between the battery unit **302** and the walls of the manufacturing mould **324** is filled with at least one moulding material.

In FIG. 3F, illustrated is a side view of the power source unit **300** that is manufactured (namely, a manufactured power source unit **300**) using the manufacturing process, comprising the damping element **330.** Herein, the manufactured power source unit **300** is obtained by separating the first mould half **322A** and the second mould half **322B.** In FIG. 3G, the cross-section view of the power source unit **300** shows an internal structure of said power source unit **300.**

FIGs. 3A-G are merely examples, which should not unduly limit the scope of the claims herein. A person skilled in the art will recognize many variations, alternatives, and modifications of embodiments of the present disclosure.

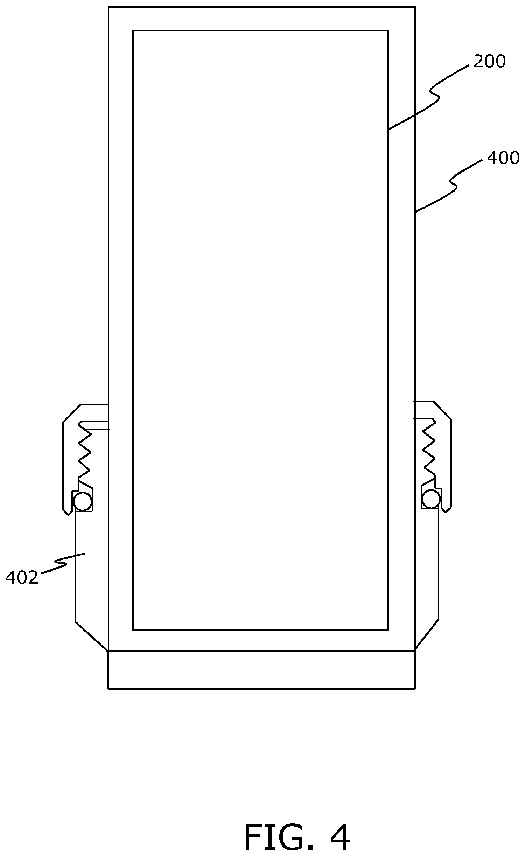

Referring to FIG. 4, illustrated is a cross-section view of a device **400** comprising a power source unit **300** of FIG. 3F, in accordance with an embodiment of the present disclosure. Herein, the power source unit **300** is operatively connected to a device **400.** The device **400** comprises a mounting surface **402** for a sensor (for example, such as an acceleration transducer). The device **400** has a rigid internal structure **404** in which the power source unit **300** is arranged.

FIG. 4 is merely an example, which should not unduly limit the scope of the claims herein. A person skilled in the art will recognize many variations, alternatives, and modifications of embodiments of the present disclosure.

The aforementioned steps are only illustrative and other alternatives can also be provided where one or more steps are added, one or more steps are removed, or one or more steps are provided in a different sequence without departing from the scope of the claims herein.

## Claims

1. A method for manufacturing a power source unit (200, 300), the method comprising:
assembling a battery unit (302) by:
arranging a first terminal (210A, 304A) and a second terminal (210B, 304B) on a printed circuit board (PCB) (202, 306) on opposite edges of the PCB;
applying a first adhesive (212, 308) on an area on the PCB between the first terminal and the second terminal;
attaching a battery (204, 310) with the first adhesive to the PCB;
attaching a first electrode (214A, 312A) of the battery to the first terminal and a second electrode (214B, 312B) of the battery to the second terminal; and
attaching a cap (206, 314), comprising a protrusion (220, 316), at least partly over a portion of the battery;
inserting the battery unit in a first mould half (322A);
removably attaching a second mould half (322B) to the first mould half to form a manufacturing mould (324);
clamping the protrusion between the first mould half and the second mould half to keep the battery unit stationary and at least partly apart from walls of the manufacturing mould;
filling volume (328) between the battery unit and the walls of the manufacturing mould with at least one moulding material to form a damping element (208, 330);
curing the at least one moulding material; and
separating the first mould half and the second mould half from each other to obtain the manufactured power source unit.

2. The method of claim 1, wherein the cap (206, 314) further comprising an extension (224, 318), wherein at the step of clamping the protrusion (220, 316) between the first mould half (322A) and the second mould half (322B), the extension keeps the battery unit (302) stationary on a centre line of the manufacturing mould, wherein the centre line also passes centrally through the protrusion.

3. The method of claim 2, further comprising applying a second adhesive (226, 320) on an inner side of the extension (224, 318).

4. The method of any of claims 1-3, wherein the first mould half (322A) comprises a first support (326A) aligned with at least two contact pads (332A-B) of the PCB (202, 306), and the second mould half(322B) comprises a second support (326B) opposite to the first support, wherein at the step of clamping the protrusion (220, 316) between the first mould half and the second mould half, the first support and the second support keeps the battery unit (302) stationary on the centre line within the manufacturing mould.

5. The method of any of claims 1-4, wherein when the at least one moulding material comprises a first moulding material and a second moulding material, wherein at the step of filling the volume (328) between the battery unit (302) and the walls of the manufacturing mould (324) with the at least one moulding material, the first moulding material is filled in a portion within the volume, and the second moulding material is filled in a remaining portion within the volume.

6. The method of any of claims 1-5, wherein the at least one moulding material is at least one of: an elastic material, an elastomeric material, a non-homogenous material.

7. The method of the claim 1, further comprising curing the first adhesive (308) applied on the area on the PCB for attaching the battery thereto, prior to attaching the first electrode (214A, 312A) of the battery (204, 310) to the first terminal (210A, 304A) and the second electrode (214B, 312B) of the battery to the second terminal (210B, 304B).

8. The method of any of the claims 1-7, further comprising applying a protective coating over the attached first electrode (214A, 312A) and the attached second electrode (214B, 312B).

9. The method of any of the claims 1-8, wherein the first mould half (322A) and the second mould half (322B) are made of a fabrication material that is resistant to a curing temperature of the at least one moulding material, wherein the fabrication material is selected from at least one of: stainless steel, aluminium alloy, silicon rubber, polymer.

10. The method of any of claims 1-9, wherein the at least one moulding material is a thermal insulating material adapted to protect the battery unit (302) from external temperature variations.

11. The method of claim 1, wherein step of filling the volume (328) with at least one moulding material employs an injection moulding process, a low pressure casting process, a hot melting process or a combination of the aforementioned.

12. The method of any of claims 1-11, wherein the cured damping element (208, 330) is adapted for providing mechanical shock absorption and vibration damping properties.

13. The method of claim 2, wherein the method comprises using a gasket to keep the battery unit (302) stationary on a centre line of the manufacturing mould.

14. The method of any of claim 1-13, wherein the power source unit (200, 300) is designed to be received in a device (400), when in use.

15. The method of any of claims 1-17, further comprising manufacturing the cap (206, 314) of the power source unit (200, 300) using a non-conductive material.
